(19) Europäisches Patentamt / European Patent Office / Office européen des brevets

(11) **EP 2 009 453 B1**

(12) **FASCICULE DE BREVET EUROPEEN**

(45) Date de publication et mention
de la délivrance du brevet:
**27.04.2011 Bulletin 2011/17**

(51) Int Cl.:
***G01R 15/18*** *(2006.01)*

(21) Numéro de dépôt: **07405183.0**

(22) Date de dépôt: **28.06.2007**

(54) **Capteur de courant Rogowski**

Rogowski-Stromsensor

Rogowski current sensor

(84) Etats contractants désignés:
**AT BE BG CH CY CZ DE DK EE ES FI FR GB GR
HU IE IS IT LI LT LU LV MC MT NL PL PT RO SE
SI SK TR**

(43) Date de publication de la demande:
**31.12.2008 Bulletin 2009/01**

(73) Titulaire: **LIAISONS ELECTRONIQUES-
MECANIQUES
LEM S.A.
1228 Plan-les-Ouates (CH)**

(72) Inventeur: **Turpin, Pierre
74800 La Roche sur Foron (FR)**

(74) Mandataire: **Reuteler, Raymond Werner
Reuteler & Cie SA
Chemin de la Vuarpillière 29
1260 Nyon (CH)**

(56) Documents cités:
**WO-A-99/54740        DE-U1- 29 706 641
JP-A- 8 031 665        US-A- 3 434 052
US-B1- 6 313 623**

## Description

La présente invention concerne un capteur de courant à boucle Rogowski.

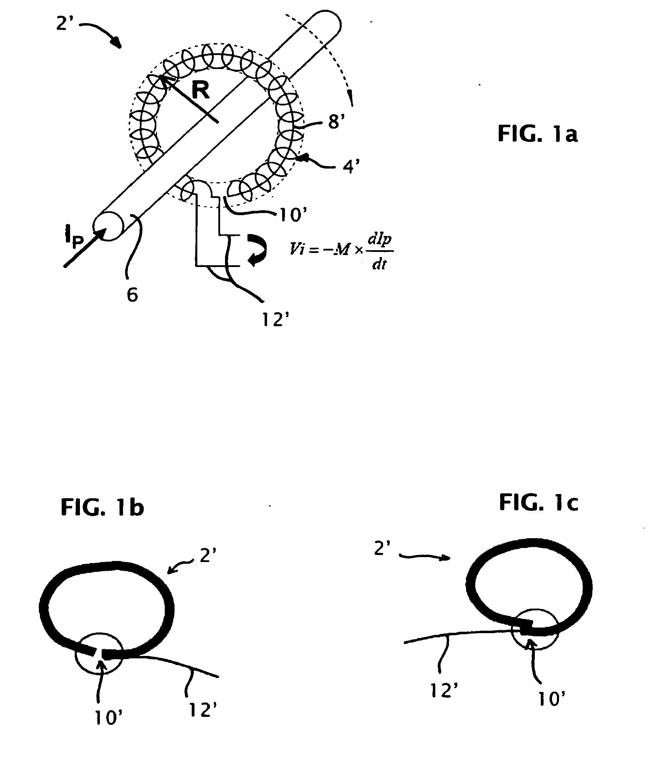

Faisant référence à la figure 1, la boucle de Rogowski connue 2' comporte, en principe, un bobinage 4' uniformément réparti autour d'un conducteur primaire 6, et un fil de retour 8' suivant l'axe médian de la bobine. Selon le théorème d'Ampère et la loi de Faraday, si la boucle effectue un parcours fermé autour du conducteur, celle-ci restitue un signal proportionnel à la dérivée du courant circulant dans le conducteur primaire et proportionnel également à l'inductance mutuelle M bobine / conducteur

$$Vi = -M \times \frac{dIp}{dt}$$

Selon cette théorie et dans l'hypothèse où la bobine est parfaite (répartition des spires et fermeture), le signal ne dépend que des différentes contributions de courant à l'intérieur du parcours, à l'exclusion de tout ce qui se trouve à l'extérieur.

L'un des intérêts de la boucle de Rogowski est que l'on peut la réaliser sous une forme flexible de manière à pouvoir facilement l'ouvrir et la refermer sur le conducteur à mesurer.

Le point de re-fermeture 10' est par contre critique dans le sens où il crée une discontinuité du parcours d'Ampère générant une certaine sensibilité aux conducteurs extérieurs d'une part, et à la position du conducteur primaire à mesurer d'autre part.

L'art aujourd'hui, consiste à porter un grand soin au système de re-fermeture, d'un point de vue mécanique (précision du positionnement) et/ou d'utiliser des artifices électriques comme des spires supplémentaires de compensation sans toutefois garantir un résultat meilleur que 1 à 2% d'erreur. La difficulté est accentuée par le fait qu'une des extrémités doit être reliée au câble de liaison 12'. Les solutions de fermeture généralement retenues consistent à faire se chevaucher les deux extrémités de la boucle (Fig 1b) ou à faire coïncider les deux extrémités (Fig 1c) mais dont la réalisation nécessite de laisser un léger espace. On comprend aisément que ce chevauchement ou cet espace résiduel tendent à augmenter la discontinuité et donc la distorsion de la mesure.

Dans le document WO 99/54740, un capteur de courant comprenant une bobine Rogowski est décrit. Un intégrateur passif en deux parties est connecté aux extrémités de la bobine, les parties étant connectées par un câble coaxial.

Dans le document US 6,313,623, une bobine Rogowski pour mesurer un courant dans un conducteur est décrite. La bobine comprend des premières et deuxièmes spires connectées en série.

Au vu des inconvénients précités, un but de l'invention est de fournir un capteur de courant à boucle Rogowski, qui est précis, adaptable, facile à utiliser et économe.

Des buts de l'invention sont réalisés par le capteur de courant à boucle Rogowski selon la revendication 1.

Dans la présente invention, un capteur de courant à boucle Rogowski comprenant un bobinage s'étendant entre deux extrémités configuré pour pouvoir être disposé autour d'un conducteur primaire dans lequel un courant à mesurer circule en séparant et en rapprochant lesdites extrémités. Le capteur comporte un mécanisme de fermeture disposé aux extrémités du bobinage. Le mécanisme comprend un circuit magnétique s'étendant entre lesdites extrémités quand la boucle est fermée. Le circuit magnétique peut être formé par un corps ayant une grande perméabilité magnétique, telle qu'un corps contenant ou constitué d'une ferrite.

De préférence, le corps comprend des cavités ou parties d'une cavité dans lesquelles les extrémités du bobinage sont logées.

Avantageusement, le corps de matériau ferromagnétique permet de fermer la boucle de Rogowski très facilement tout en limitant les imprécisions de mesure dues à une fermeture imparfaite de la boucle et donc une discontinuité du parcours d'Ampère. L'insertion d'un morceau de circuit magnétique englobant les deux extrémités du bobinage réduit, voire élimine, la discontinuité du parcours d'Ampère.

Le corps peut avantageusement être formé d'une pièce intégrale, par exemple par moulage.

Dans une variante avantageuse, le corps est fixé de manière permanente à une des extrémités du bobinage, l'autre extrémité du bobinage étant enfichable de manière non permanente dans une cavité correspondante du corps. Les extrémités du bobinage peuvent être alignées ou alors se chevaucher quand la boucle est fermée.

D'autres buts et aspects avantageux de l'invention ressortiront des revendications, de la description détaillée ci-après, ainsi que des dessins annexés, dans lesquels :

La Fig. 1a est une vue en perspective d'un capteur de courant à boucle Rogowski selon un principe connu ;

Les Fig. 1b et 1c sont des vues d'un capteur de courant à boucle Rogowski selon un principe connu ;

La Fig. 2a est une vue en perspective d'un capteur de courant à boucle Rogowski selon une première forme d'exécution de l'invention, (illustrée pour simplification, sans gainage ni support pour la bobine) ;

La Fig. 2b est une vue en coupe de la partie de fermeture du capteur de la figure 2a selon une première variante;

La Fig. 2c est une vue en coupe de la partie de fermeture du capteur de la figure 2a selon une deuxième variante;

La Fig. 3a est une vue en perspective d'un capteur de courant à boucle Rogowski, selon une deuxième forme d'exécution de l'invention, en position ouverte (illustrée, pour simplification, sans gainage ni support pour la bobine);

La Fig. 3b est une vue en perspective du capteur de la figure 3a en position fermée ;

Les Fig. 3c à 3f sont des vues en coupe de quatres variantes de la partie de fermeture du capteur de la figure 3b.

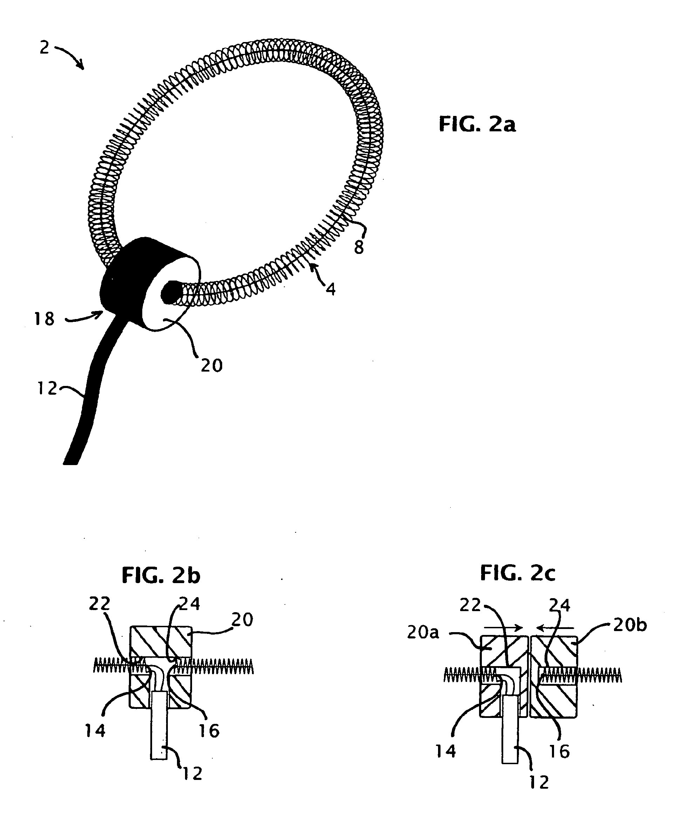

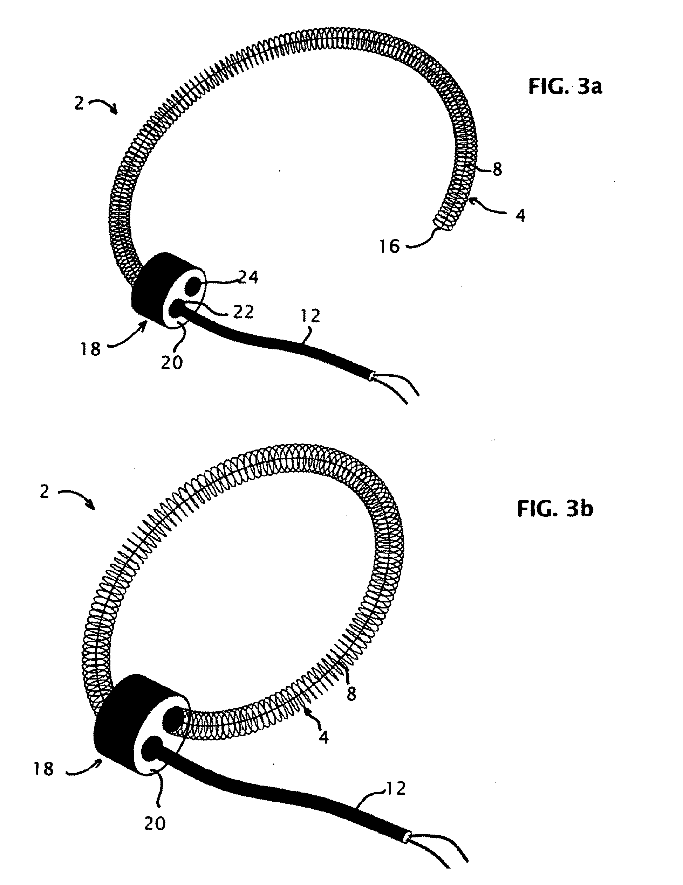

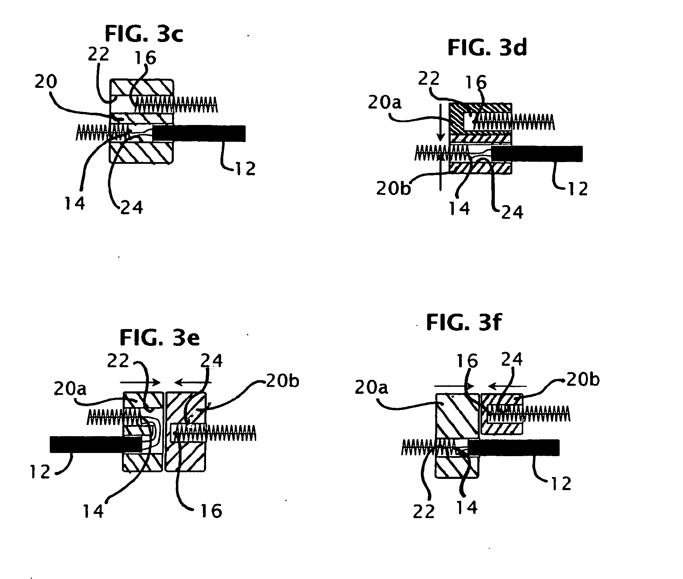

Faisant référence aux figures 2a-2c et 3a-3f, un capteur de courant à boucle de Rogowski 2 comprend un bobinage 4 conducteur autour d'un support diélectrique (non illustré), un fil de retour 8 conducteur suivant essentiellement l'axe médian de la bobine connecté à une extrémité 14 du bobinage, une gaine diélectrique (non illustrée) autour du bobinage 4, et un câble 12 ou autre dispositif de connexion connecté à l'autre extrémité 16 du bobinage et au fil de retour. Le bobinage peut être formé par un fil conducteur essentiellement uniformément bobiné autour du support diélectrique, ou par un conducteur déposé sur un support diélectrique, ou encore par d'autres procédés de fabrication permettant de disposer des spires d'un conducteur autour ou dans un support pour former un bobinage régulier. Le profil de la section du support est de préférence circulaire, mais il est aussi envisageable d'avoir d'autres profils de section, tels que rectangulaires, ovales, triangulaires, hexagonaux etc.

Au lieu d'un fil de retour médian, la boucle de Rogowski peut comporter un deuxième bobinage sur le premier bobinage, de sorte à ce que les deux extrémités du fil conducteur constituant les bobinages se retrouvent du même côté. Par simplification, nous entendons ci-après par le terme « bobinage » de la boucle de Rogowski, un bobinage avec un fil de retour ou deux bobinages.

Le câble 12 ou autre dispositif de connexion est destiné à être connecté à un circuit de traitement (non illustré) pour le traitement du signal fourni par le bobinage, afin de générer une valeur de mesure du courant circulant dans un conducteur primaire 6.

Dans les formes d'exécution illustrées, le bobinage 4, le support diélectrique, et la gaine forment une boucle souple ou flexible pouvant être ouverte (tel qu'illustré dans la fig. 3a) et refermé (tel qu'illustré dans les figs. 2a, 2b, 3b-3f). Cela permet de positionner la boucle autour d'un conducteur primaire 6. Il est également envisageable, dans le cadre de l'invention, de réaliser le bobinage sur un support rigide, par exemple en deux parties avec une charnière pivotante ou souple reliant l'une des extrémités respectives de chaque partie.

Le capteur de courant à boucle de Rogowski 2 selon l'invention comprend en outre un mécanisme de fermeture 18 configuré pour relier les deux extrémités 14, 16 du bobinage lorsque le capteur est en fonctionnement autour d'un conducteur primaire. Le mécanisme de fermeture comprend un circuit magnétique comportant un corps 20, 20a, 20b en une ou deux parties en un matériau ferromagnétique, c'est-à-dire ayant une perméabilité magnétique élevée par rapport à la perméabilité magnétique de l'air, reliant les extrémités 14, 16 du bobinage. Dans les formes d'exécution illustrées, le corps comprend des cavités ou logements 22, 24 ou parties de logements dans lesquels les extrémités 14, 16 sont logées afin d'être entourées par le matériau ferromagnétique. Le matériau ferromagnétique peut être par exemple une ferrite ou un alliage fer-silicium, fer-nickel, matériaux amorphes, nanocristallins, ou un matériau plastique chargé de matière magnétique. Le corps 20, 20a, 20b peut avantageusement être moulé en une ou deux pièces d'une ferrite ou dans une matière thermoplastique contenant un matériau ferromagnétique, par exemple des particules d'un matériau ferromagnétique. Il est aussi possible d'intégrer, par assemblage ou surmoulage, le corps de matériau ferromagnétique dans un corps ou boîtier d'un autre matériau, tel que du plastique.

L'extrémité 14 avec le point de retour est insérable ou positionnable de manière amovible ou non permanente dans le logement. L'extrémité 16 connectée au dispositif de connexion ou au câble 12 est de préférence logée de manière fixe au mécanisme de fermeture par des moyens de fixation permanents (par exemple collés, sertis, ou surmoulés) dans la cavité ou la partie de cavité correspondante du corps. L'extrémité de connexion 16 du bobinage, le dispositif de connexion et le mécanisme de fermeture peuvent donc être solidaires. L'extrémité 16 du bobinage peut toutefois également être connectée au dispositif de connexion ou au câble de manière non permanent (par exemple par un clip de fixation mécanique - non illustré) afin d'être démontable et séparable du mécanisme de fixation.

Le corps en matériau ferromagnétique a également l'avantage de servir de blindage autour des fils de raccordement entre la bobine et le câble, cette partie étant sensible aux champs magnétiques et pouvant introduire une erreur sur le signal produit.

Afin de réduire encore les signaux parasites pouvant être induits dans l'interface bobine/câble et câble lui-même, on peut utiliser un câble de raccordement blindé magnétiquement pénétrant dans le corps en matériau ferromagnétique afin d'assurer la continuité du dit blindage. En particulier, on peut utiliser un câble dont la gaine en matière thermoplastique est chargée d'une matière ferromagnétique.

Le corps du mécanisme de fermeture peut être formé en une pièce 20 tel que illustré dans les figures 2b et 3c, ou deux pièces 20a, 20b tel que illustré dans les figures 2c et 3d à 3f, ou plus de deux pièces, pouvant êtres couplées ensemble lorsque le capteur est assemblé autour d'un conducteur primaire. Différents moyens de fixation ou de verrouillage (p. ex. vis, clip) peuvent être utilisés pour l'assemblage et la fermeture des parties du corps.

Dans la forme d'exécution illustrée dans les figures 2a, 2b, les cavités ou parties de cavité 22, 24 logeant les extrémités du bobinage sont disposées en ligne, alors que dans la forme d'exécution illustrée dans les figures 3a à 3c les cavités ou parties de cavité 22, 24 se chevauchent. Dans ces deux formes d'exécution, l'extrémité libre 16 du bobinage peut être simplement insérée dans la cavité correspondante pour refermer la boucle autour d'un conducteur primaire. L'extrémité libre 16 du bobinage peut être maintenue dans la cavité par force de frottement, ou par un moyen de fixation.

Dans le cadre de l'invention, au lieu d'avoir l'extrémité 16 insérable dans le logement du corps, il est aussi possible de fixer chaque extrémité du bobinage de manière permanente dans des parties respectives de corps séparables 20a, 20b et pouvant êtres couplées ensemble afin de monter et fermer le bobinage autour d'un conducteur primaire tel que illustré dans les figures 2c et 3d à 3f.

Le mécanisme de fermeture 18 peut comprendre en outre un boîtier (non illustré), dans lequel le corps ou les parties de corps en matériau ferromagnétique sont montés, ainsi que d'autres composants tel qu'un circuit de traitement du signal de mesure (non illustré) ou encore des bornes de connexion (au lieu du câble) pour la connexion du capteur à une fiche de connexion d'un dispositif externe.

Dans le cadre de l'invention, il est possible de remplacer une cavité du corps ferromagnétique dans laquelle pénètre une extrémité de la bobine par une protubérance du corps pénétrant dans l'extrémité de la bobine, afin de relier les extrémités du bobinage par un circuit magnétique.

Le corps de matériau ferromagnétique permet de fermer la boucle de Rogowski très facilement tout en limitant les imprécisions de mesure dues à une fermeture imparfaite de la boucle et donc une discontinuité du parcours d'Ampère. L'insertion d'un morceau de circuit magnétique englobant, ou inséré dans, les deux extrémités du bobinage réduit, voire élimine, la discontinuité du parcours d'Ampère. Un matériau ayant une perméabilité par exemple 50 à 1000 fois supérieure à celle de l'air crée un court-circuit magnétique, ce qui reviendrait à faire coïncider les deux extrémités. Du point de vue magnétique, le parcours d'Ampère est alors complet et essentiellement sans discontinuité, améliorant notablement l'effet d'insensibilité aux champs magnétiques extérieurs à la boucle et au positionnement du conducteur primaire à mesurer à l'intérieur de la boucle.

Des avantages du capteur selon l'invention sont :

- Re-fermeture facile et fiable du bobinage autour d'un conducteur primaire : dès que l'extrémité libre pénètre dans le circuit magnétique, le parcours est complet et la précision optimale
- Pas besoin d'une mécanique complexe ou de précision pour fixer l'extrémité libre
- Utilisation possible de matériau ferrite peu cher et de forme adaptée (forme obtenue par moulage)
- Chevauchement des extrémités sans conséquence sur la sensibilité aux champs extérieurs ou au positionnement du conducteur primaire.

**Revendications**

1. Capteur de courant à boucle Rogowski comprenant un bobinage (4) s'étendant entre deux extrémités (14, 16) configuré pour pouvoir être disposé autour d'un conducteur primaire dans lequel un courant à mesurer circule en séparant et en rapprochant lesdites extrémités, et un mécanisme de fermeture (18) disposé aux extrémités du bobinage, **caractérisé en ce que** le mécanisme de fermeture comprend un circuit magnétique s'étendant entre lesdites extrémités quand la boucle est fermé, le circuit magnétique comprenant un corps (20, 20a, 20b) ayant une grande perméabilité magnétique, au moins une partie du corps étant fixé de manière permanente à au moins une des extrémités du bobinage, l'autre extrémité du bobinage étant enfichable de manière non permanente dans une cavité correspondante du corps.

2. Capteur selon la revendication précédente, **caractérisé en ce que** le corps comprend au moins une cavité ou partie de cavité (22, 24) dans laquelle au moins une extrémité du bobinage est logée.

3. Capteur selon la revendication 1 ou 2, **caractérisé en ce que** le corps comprend au moins une protubérance insérée dans une extrémité du bobinage.

4. Capteur selon la revendication 1, 2 ou 3, **caractérisé en ce que** le corps comporte de la ferrite.

5. Capteur selon l'une quelconque des revendications 1 à 4, **caractérisé en ce que** le corps est une pièce intégrale.

6. Capteur selon l'une quelconque des revendications 1 à 4, **caractérisé en ce que** le corps comprend au moins deux parties séparables.

7. Capteur selon l'une des revendications précédentes, **caractérisé en ce que** l'autre extrémité du bobinage est fixée de manière permanente à une autre partie du corps.

**8.** Capteur selon l'une quelconque des revendications précédentes, **caractérisé en ce que** les extrémités du bobinage se chevauchent quand la boucle est fermée.

**9.** Capteur selon l'une quelconque des revendications 1 à 7, **caractérisé en ce que** les extrémités du bobinage sont alignées quand la boucle est fermée.

**10.** Capteur selon l'une quelconque des revendications précédentes, **caractérisé en ce qu'**un câble de raccordement (12) est connecté à une extrémité du bobinage, le câble comprenant un blindage magnétique pénétrant dans le circuit magnétique.

**11.** Capteur selon la revendication précédente, **caractérisé en ce que** le blindage du câble de raccordement comprend une gaine en matière thermoplastique chargée d'une matière ferromagnétique.

**Claims**

**1.** A current sensor with a Rogowski loop comprising a coil (4) extending between two ends (14, 16) configured so as to be able to be positioned around a primary conductor in which flows a current to be measured by separating said ends and bringing them closer to each other, and a closure mechanism (18) positioned at the ends of the coil, **characterized in that** the closure mechanism comprises a magnetic circuit, extending between said ends when the loop is closed, the magnetic circuit comprising a body (20, 20a, 20b) having a high magnetic permeability, at least one portion of the body being permanently attached to at least one of the ends of the coil, the other end of the coil being pluggable in a non-permanent way into a corresponding cavity of the body.

**2.** The sensor according to the preceding claim, **characterized in that** the body comprises at least one cavity or cavity portion (22, 24) in which at least one end of the coil is housed.

**3.** The sensor according to claim 1 or 2, **characterized in that** the body comprises at least one protrusion inserted into one end of the coil.

**4.** The sensor according to claim 1, 2 or 3, **characterized in that** the body includes ferrite.

**5.** The sensor according to any of claims 1 to 4, **characterized in that** the body is an integral part.

**6.** The sensor according to any of claims 1 to 4, **characterized in that** the body comprises at least two separable portions.

**7.** The sensor according to one of the preceding claims, **characterized in that** the other end of the coil is permanently attached to another portion of the body.

**8.** The sensor according to any of the preceding claims, **characterized in that** the ends of the coil overlap when the loop is closed.

**9.** The sensor according to any of claims 1 to 7, **characterized in that** the ends of the coil are aligned when the loop is closed.

**10.** The sensor according to any of the preceding claims, **characterized in that** a connecting cable (12) is connected to one end of the coil, the cable comprising magnetic shielding penetrating into the magnetic circuit.

**11.** The sensor according to the preceding claim, **characterized in that** the shielding of the connecting cable comprises a sheath in thermoplastic material filled with a ferromagnetic material.

**Patentansprüche**

**1.** Stromsensor mit Rogowskispule, die eine Wicklung (4) umfasst, die sich zwischen zwei Enden (14, 16) erstreckt, die konfiguriert ist, um einen primären Leiter angeordnet zu sein, in dem ein zu messender Strom zirkuliert, indem die Enden getrennt und angenähert werden, und einen an den Enden der Wicklung angeordneten Schließmechanismus (18), **dadurch gekennzeichnet, dass** der Schließmechanismus einen Magnetkreis umfasst, der sich zwischen den Enden erstreckt, wenn die Spule geschlossen ist, wobei der Magnetkreis einen Körper (20, 20a, 20b) mit einer hohen magnetischen Permeabilität umfasst, wobei mindestens ein Abschnitt des Körpers ständig an mindestens einem der Enden der Wicklung befestigt ist, wobei das andere Ende der Wicklung nicht ständig in eine entsprechende Öffnung des Körpers einbringbar ist.

**2.** Sensor nach vorangehendem Anspruch, **dadurch gekennzeichnet, dass** der Körper mindestens eine Öffnung oder einen Öffnungsabschnitt (22, 24) umfasst, in dem mindestens ein Ende der Wicklung untergebracht ist.

**3.** Sensor nach Anspruch 1 oder 2, **dadurch gekennzeichnet, dass** der Körper mindestens eine in ein Ende der Wicklung eingepasste Ausstülpung umfasst.

**4.** Sensor nach Anspruch 1, 2 oder 3, **dadurch gekennzeichnet, dass** der Körper Ferrit aufweist.

5. Sensor nach einem der Ansprüche 1 bis 4, **dadurch gekennzeichnet, dass** der Körper ein gesamtes Teil ist.

6. Sensor nach einem der Ansprüche 1 bis 4, **dadurch gekennzeichnet, dass** der Körper mindestens zwei trennbare Abschnitte umfasst.

7. Sensor nach einem der vorangehenden Ansprüche, **dadurch gekennzeichnet, dass** das andere Ende der Wicklung ständig an einem anderen Abschnitt des Körpers befestigt ist.

8. Sensor nach einem der vorangehenden Ansprüche, **dadurch gekennzeichnet, dass** sich die Enden der Wicklung überlappen, wenn die Spule geschlossen ist.

9. Sensor nach einem der Ansprüche 1 bis 7, **dadurch gekennzeichnet**, das die Enden der Wicklung ausgerichtet sind, wenn die Spule geschlossen ist.

10. Sensor nach einem der vorangehenden Ansprüche, **dadurch gekennzeichnet, dass** ein Verbindungskabel (12) an einem Ende der Wicklung angeschlossen ist, wobei das Kabel eine magnetische Armierung umfasst, die in das Magnetfeld hineinreicht.

11. Sensor nach vorangehendem Anspruch, **dadurch gekennzeichnet, dass** die Armierung des Verbindungskabels einen Mantel aus thermoplastischem Material umfasst, das mit einem ferromagnetischen Material angereichert ist.

2'

R

8'

4'

10'

$I_P$

6

$Vi = -M \times \dfrac{dIp}{dt}$

12'

**FIG. 1a**

**FIG. 1b**

2'

10'    12'

**FIG. 1c**

2'

12'    10'

**FIG. 2a**

**FIG. 2b**

**FIG. 2c**

FIG. 3a

FIG. 3b

**FIG. 3c**

**FIG. 3d**

**FIG. 3e**

**FIG. 3f**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 9954740 A

- US 6313623 B